## Europäisches Patentamt

## European Patent Office

## Office européen des brevets

(11) Veröffentlichungsnummer: **0 286 623**
**A2**

(12)
# EUROPÄISCHE PATENTANMELDUNG

(21) Anmeldenummer: **88890059.4**

(51) Int. Cl.⁴: **H 03 B 23/00**

(22) Anmeldetag: **17.03.88**

(30) Priorität: **09.04.87 AT 878/87**

(43) Veröffentlichungstag der Anmeldung:
**12.10.88 Patentblatt 88/41**

(84) Benannte Vertragsstaaten:
**AT BE CH DE ES FR GB GR IT LI LU NL SE**

(71) Anmelder: **SONAIR MESSGERÄTE GESELLSCHAFT M.B.H.**
**Grosse Neugasse 8**
**< <0/2A> > A-1040 Wien (AT)**

(72) Erfinder: **Metchev, Alexander, Dr.**
**Gentzgasse 14/13/16**
**A-1180 Wien (AT)**

(74) Vertreter: **Atzwanger, Richard Dipl.Ing.**
**Patentanwälte Dipl.-Ing. Anton Atzwanger, Dipl.-Ing. Richard Atzwanger Mariahilfer Strasse 1c**
**A-1060 Wien (AT)**

(54) **Schaltungsanordnung zur Erfassung von chirpmodulierten Signalen, insbesondere zur Erfassung von chirpmodulierten Ultraschallsignalen.**

(57) Schaltungsanordnung zur Erfassung von chirpmodulierten Signalen mit mindestens zwei Zählern, einem Oszillator sowie einer Kette von Gattern und getakteten Schieberegistern. Diese enthält einen digitalen Frequenzdiskriminator, durch welchen die Frequenzänderungen der eingelangten chirpmodulierten Signale erfaßt und digitalisiert werden, wobei die digitalen Ausgangssignale des Frequenzdiskriminators einem sequentiellen Pulsdetektor, der aus einer Kette von ODER-Gattern (75) und vom Oszillator (36) durch Zähler (40) getakteten Schieberegistern (70) besteht, zugeführt werden, in welchem diese Signale zeitlich aufeinanderfolgend aufsummiert werden, so daß der digitale Frequenzdiskriminator (2) und der sequentielle Pulsdetektor (70, 75) ein an die chirpmodulierten Signale angepaßtes Filter bilden, wobei nach Erreichung eines vorgegebenen Schwellwertes von mindestens einer aus einer Mehrzahl von Schwellwertschaltungen (80) an einen Prioritätsdekoder (90) ein Ausgangssignal abgegeben wird und vom Prioritätsdekoder (90) die Frequenz und den Zeitpunkt des eingelangten chirpmodulierten Signals ermittelt wird, wodurch dieses in einem vorgegebenen Frequenzbereich festgestellt und korrelativ ausgewertet wird, worauf das Ausgangssignal des Prioritätsdekoders (90) an eine Signalanzeige bzw. an einen Speicher abgegeben wird.

EP 0 286 623 A2

Fig. 1a

Fig. 1b

## Beschreibung

### Schaltungsanordnung zur Erfassung von chirpmodulierten Signalen, insbesondere zur Erfassung von chirpmodulierten Ultraschallsignalen

Die Erfindung betrifft eine Schaltungsanordnung zur Erfassung von chirp-modulierten Signalen, insbesondere zur Erfassung von chirp-modulierten Ultraschallsignalen.

In der Meß- und Empfangstechnik besteht die Aufgabe, frequenzveränderliche Signale zu erfassen und deren Signalinhalte auszuwerten bzw. in einem bestimmten Frequenzband enthaltene frequenzmodulierte Signale festzustellen. Insbesondere bezieht sich diese Aufgabe auf chirpsmodulierte Signale. Es sind dies solche Signale, deren Frequenz sich mit der Zeit ändert, wobei sie sich vergrößert oder verkleinert.

Der vorliegenden Erfindung liegt die Aufgabe zugrunde, eine Schaltungsanordnung zu schaffen, durch welche chirpsmodulierte Signale innerhalb von im akustischen Bereich und im Ultraschallbereich liegenden Frequenzbändern korrelativ erfaßt und ausgewertet werden können. Dabei soll für die untere Grenze der Frequenzbänder kein Wert gesetzt sein, wogegen sich die obere Grenze der Frequenzbänder zwischen 1 MHz und 10 MHz befinden kann. Ergänzend wird darauf verwiesen, daß ähnliche Aufgaben bei Frequenzen oberhalb von 10 MHz durch die Radartechnik gelöst sind, daß jedoch die aus der Radartechnik bekannten Technologien auf Frequenzbereiche unterhalb von 10 MHz nicht übertragbar sind.

In der Meß- und Empfangstechnik besteht das Problem der Erfassung von unbekannten Signalen, die sich innerhalb von bestimmten Frequenzbereichen befinden. Durch die Erfassung derartiger Signale wird das "Einrasten" von phasensensitiven PLL-Schaltungen (Phase-Locked-Loops) ermöglicht. Unter dem Begriff "Einrasten" wird dabei das Synchronisieren der Frequenz und der Phase des von der PLL-Schaltung abgegebenen Signals mit der Frequenz und der Phase des empfangenen Signals verstanden, wodurch eine weitere Verarbeitung des empfangenen Signals durch die PLL-Schaltung ermöglicht wird. Bekannte Schaltungsanordnungen, die dazu dienen, in vorgegebenen Frequenzbereichen bestimmte Signale aufzufinden, enthalten eine Vielzahl von Filterbänken, mittels welcher Signalanalysen durchgeführt werden können. Diesen bekannten Schaltungsanordnungen haftet jedoch der Nachteil an, daß sie einen sehr großen schaltungsmäßigen Aufwand bedingen und daß sie eine so große Auswertzeit benötigen, daß sie den Anforderungen der modernen Technik im besonderen Anwendungsbereich nicht entsprechen. Dies gilt insbesondere für das Aufsuchen bzw. Auswerten von einmaligen, sogenannten transienten Signalen, wofür korrelative Signalverarbeitungen (sogenannte Optimalfilter) erforderlich sind.

Der Erfindung liegt somit die Aufgabe zugrunde, eine Schaltungsanordnung zu schaffen, die unter Verwendung der Digitaltechnik eine schnelle und genaue Erfassung von Signalen, insbesondere von transienten, frequenzveränderlichen Signalen ermöglicht. Diese Aufgabe wird erfindungsgemäß durch die Kombination eines digitalen Frequenzdiskriminators mit einem sequentiellen Pulsdetektor, diesem zugeordneten Schwellwertschaltungen, einem Prioritätsdekoder sowie einer Signalanzeige und bzw. oder einem Speicher gelöst, durch welche Kombination ein chirpsmoduliertes Signal in einem vorgegebenen Frequenzbereich festgestellt und korrelativ ausgewertet wird.

Vorzugsweise enthält der digitale Frequenzdiskriminator ein Flip-Flop, einen Abtastgenerator, mindestens zwei Zähler, eine Dekodierschaltung sowie weiters einen Phasendetektor, einen Steuerschalter und ein Tiefpaßfilter, wobei die letztgenannten Bestandteile mit den Zählern eine PLL-Schaltung zur Regelung der Frequenz des Abtastgenerators aufgrund eines Referenzsignales bilden. Dabei kann dem Eingang des Flip-Flop ein Bandpaßfilter zugeordnet sein, dessen Mittenfrequenz durch einen Frequenz-Spannungskonverter oder einen Frequenz-Stromkonverter, welche vom Abtastgenerator steuerbar sind, einstellbar ist.

Vorzugsweise ist der Ausgang des Bandpaßfilters an einen Spannungskomparator gelegt, dessen Ausgang über ein UND-Gatter und ein ODER-Gatter an den Set-Eingang des Flip-Flop geführt ist.

Weiters können die Ausgänge eines ersten Zählers an die Eingänge eines Kodierschalters, durch welchen die Länge des Zählvorganges im ersten Zähler einstellbar ist, gelegt sein. Zudem können die Ausgänge eines zweiten Zählers an die Eingänge eines Zwischenspeichers gelegt sein, der zur Speicherung der momentanen Meßwerte dient und dessen Ausgänge an die Dekodierschaltung gelegt sind. Die Ausgänge der Dekodierschaltung können an den sequentiellen Pulsdetektor gelegt sein.

Vorzugsweise sind weiters zwei weitere Zähler zur Steuerung des sequentiellen Pulsdetektors, ein Monoflop zur Steuerung eines Zwischenspeichers und ein weiteres Monoflop zur Steuerung der Schwellwertschaltungen vorgesehen. Dabei kann der sequentielle Pulsdetektor durch eine Kette von Schieberegistern, zwischen welchen ODER-Gatter angeordnet sind, gebildet sein und können die Schwellwertschaltungen durch eine Gruppe von Zählschaltungen, in welchen UND-Gatter, ODER-Gatter und Zähler angeordnet sind, gebildet sein.

Vorzugsweise ist weiters ein Teil der Ausgänge des zweiten Zählers über ein UND-Gatter und ein ODER-Gatter an den Set-Eingang des Flip-Flop gelegt und ist ein Eingang für die Steuerung mittels eines Referenzsignales über einen Inverter, ein UND-Gatter und ein ODER-Gatter an den Set-Eingang des Flip-Flop gelegt. Zudem ist vorzugsweise jeder Ausgang der Dekodierschaltung einerseits an einen Eingang des zugeordneten, zwischen zwei Schieberegisters befindlichen ODER-Gatters und andererseits an einen Eingang der zugeordneten Schwellwertschaltung gelegt, wobei der Ausgang des zugeordneten Schieberegisters an einen zweiten Eingang der Schwellwertschaltung geführt ist.

Nach einer Ausführungsvariante sind die Ausgänge eines Teiles der in den Schieberegistern befindlichen Speicherelemente herausgeführt und an Eingänge von Tri-State-Pufferschaltungen gelegt und sind die Ausgänge einer der Tri-State-Pufferschaltungen über Widerstände an den einen Eingang eines Komparators gelegt, an dessen anderen Eingang ein Spannungsteiler gelegt ist und dessen Ausgang an einen Rückkloppungseingang dieser Tri-State-Pufferschaltung geführt ist.

Eine erfindungsgemäße Schaltung ist nachstehend anhand eines ist der Zeichnung dargestellten Ausführungsbeispiels näher erläutert. Es zeigen:

Die Fig. 1a und 1b des Schaltschema einer erfindungsgemäßen Schaltung,

Fig. 2 ein Detail der Schaltung nach Fig. 1,

Fig. 3 einen Teil der Schaltung nach Fig. 1 in einer Ausführungsvariante,

Fig. 4 ein Detail der Schaltung nach Fig. 3 und

Fig. 5 Signaldiagramme mit der Darstellung der in einzelnen Punkten der Schaltung auftretenden Signalwerte.

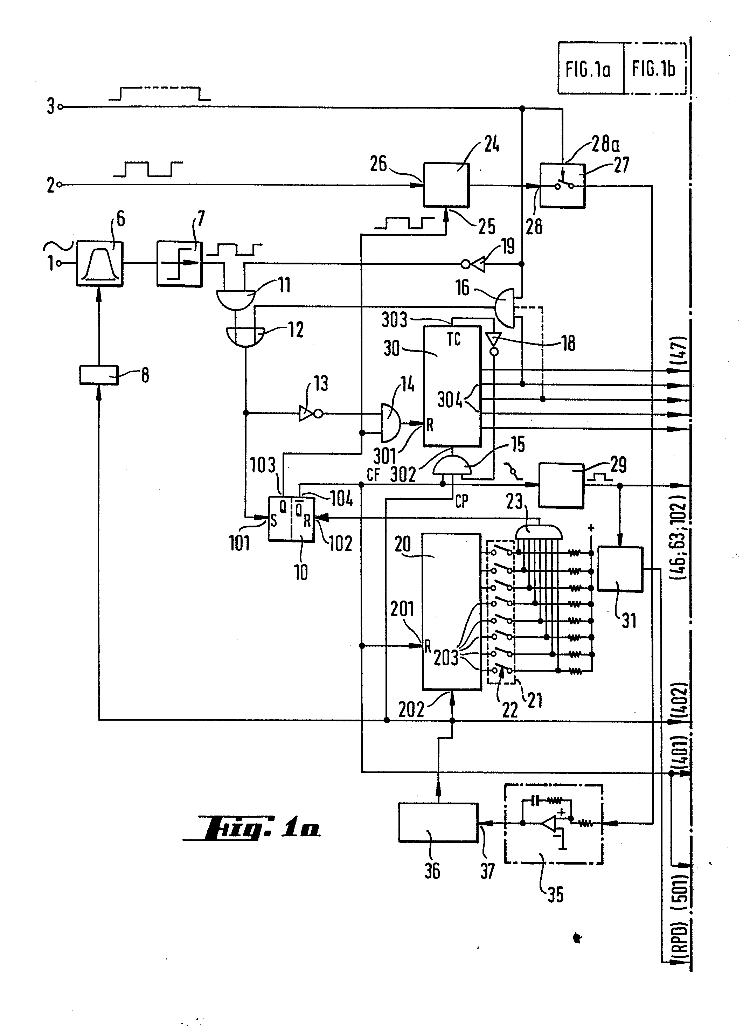

Ein erster Signaleingang 1 der Schaltung nach Fig. 1 ist an ein Bandpaßfilter 6 angelegt, dessen Ausgang an einen Spannungskomparator 7 geführt ist. Durch das Bandpaßfilter 6 wird derjenige Frequenzbereich bestimmt, in welchem Signale aufgesucht werden sollen. Durch den Spannungskomparator 7 wird das eingehende sinusförmige Signal in ein Rechtecksignal umgewandelt. Der Ausgang des Spannungskomparators 7 ist über ein UND-Gatter 11 und ein ODER-Gatter 12 an den Set-Eingang 101 eines Reset-Set Flip-Flops 10 (RS Flip-Flop) sowie über einen Inverter 13 an den einen Eingang eines UND-Gatters 14 gelegt. Der Q-Ausgang 103 des RS-Flip-Flops 10 ist über den anderen Eingang des UND-Gatters 14 an den Reset-Eingang 301 eines zweiten Zählers 30 und weiters an den einen Eingang 25 eines Phasendetektors 24, dessen anderer Eingang 26 von einem zweiten Signaleingang 2 her mit einem Referenzsignal beaufschlagbar ist, gelegt.

Der Komplementäre $\overline{Q}$-Ausgang 104 des RS-Flip-Flop 10 ist an den Reset-Eingang 201 eines ersten Zählers 20, weiters an einen Eingang eines UND-Gatters 15, dessen Ausgang an den Zähl- bzw. Takteingang 302 des zweiten Zählers 30 geführt ist, zudem an Reset-Eingänge 401 und 501 eines dritten Zählers 40 und eines vierten Zählers 50 sowie an den Eingang eines ersten Monoflops 29 gelegt.

Der Ausgang des Phasendetektors 24 ist an den Eingang 28 eines elektronisch steuerbaren Schalters 27 gelegt, der über seinen Steuereingang 28a her von einem dritten Signaleingang 3 für die Referenzsteuerung mit einem rechteckförmigen Signal beaufschlagbar ist. Der Ausgang des Schalters 27 ist an den Eingang eines Tiefpaßfilters 35 geführt, dessen Ausgang an den Steuereingang 37 eines spannungsgesteuerten Oszillators 36 (VCO), der als Takt- und Abtastsignalgeber dient, gelegt ist. Der Ausgang des Oszillators 36 ist an den Zähl- bzw. Takteingang 202 des ersten Zählers 20, an einen zweiten Eingang des UND-Gatters 15, an den Zähl- bzw. Takteingang 402 des dritten Zählers 40 und an den Eingang des als Steuerschaltung für das Tiefpaß-Filter 6 dienenden Frequenz-Spannungskonverters 8 gelegt.

Der Ausgang des ersten Monoflops 29 ist an den Eingang eines zweiten Monoflops 31, an den Steuereingang 46 eines Zwischenspeichers 45, an den Steuereingang 63 eines Decoders 60 und an den Steuereingang 102 eines Ergebnisspeichers 100 gelegt. Der zweite Zähler 30 ist mit einer Vielzahl von parallel liegenden Ausgängen 304 gebildet, die sämtliche an weitere Eingänge 47 des Zwischenspeichers 45 geführt sind. Mindestens ein mittlerer Ausgang des zweiten Zählers 30 ist an einen Eingang eines weiteren UND-Gatters 16 geführt, dessen Ausgang an einen zweiten Eingang des ODER-Gatters 12 gelegt ist. Der Steuereingang 3 für die Referenzsteuerung ist weiters an einen Eingang des UND-Gatters 16 und über einen Inverter 19 an einen weiteren Eingang des UND-Gatters 11 gelegt. Ein weiterer Ausgang 303 des zweiten Zählers 30 ist über einen Inverter 18 an einen dritten Eingang des UND-Gatters 15 gelegt.

Die Ausgänge 203 des ersten Zählers 20 sind an einen Kodierschalter 21 mit einer Vielzahl von einstellbaren Kontakten 22 gelegt. Durch der Kodierschalter 21, ist der erste Zähler 20 auf einen bestimmten Zählerinhalt vorprogrammierbar. Die Ausgänge des Kodierschalters 21 sind über ein UND-Gatter 23 an den Reset-Eingang 102 des Flip-Flops 10 gelegt.

Die einzelnen Ausgänge 48 des Zwischenspeichers 45 sind an zugeordnete Eingänge 61 des Dekoders 60 geführt, dessen N + 1 Ausgänge 62 an erste Eingänge 76 von diesen Ausgängen 62 zugeordneten ODER-Gattern 75 gelegt sind. Die ODER-Gatter 75 befinden sich jeweils zwischen zwei Schieberegistern 70 und bilden mit diesen eine Kette. Die Ausgänge 73 der Schieberegister 70 sind an zweite Eingänge 77 der ODER-Gatter 75 gelegt. Die Ausgänge 78 der ODER-Gatter 75 sind an die jeweiligen Eingänge 71 des in der Kette folgenden Schieberegisters 70 geführt. Weiters sind die Ausgänge 62 des Dekoders 60 und die Ausgänge 73 der Schieberegister 70 an zugeordnete Zählschaltungen 80 gelegt. Die Ausgänge 85 der einzelnen Zählschaltungen 80 sind an den einzelnen Zählschaltungen 80 zugeordnete Eingänge 91 eines Prioritätsdekoders 90 gelegt. Die Ausgänge 92 des Prioritätsdekoders 90 sind an die Eingänge 101 des Ergebnisspeichers 100 geführt. Der Ausgang 403 des dritten Zählers 40 ist an den Zählereingang 502 des vierten Zählers 50 und an Steuerbzw. Takeingänge 72 der Schieberegister 70 gelegt. Der Ausgang 503 des vierten Zählers 50 ist an Steuereingänge 83 der Zählschaltungen 80 gelegt.

Die einzelnen Schieberegister 70 enthalten eine Vielzahl von Speicherzellen. Die Anzahl der in den einzelnen Schieberegistern 70 vorgesehenen Speicherzellen muß der Anzahl N der Schieberegister 70 gleich sein. Nach dem Ausführungsbeispiel sind 16 Schieberegister 70 vorgesehen, wobei jedes Schieberegister 70 genau 16 Speicherzellen enthält.

Die Ausgänge 73 der Schieberegister 70 sind an erste Eingänge 81 der zugeordneten Zählschaltungen 80 gelegt und die Ausgänge 62 des Dekoders 60 sind an zweite Eingänge 82 der zugeordneten Zählschaltungen 80 gelegt. An Steuereingänge 83 der Zählschaltungen 80 ist der Ausgang 503 des vierten Zählers 50 gelegt und an Reset-Eingänge 84 ist der Ausgang des zweiten Monoflops 31 gelegt.

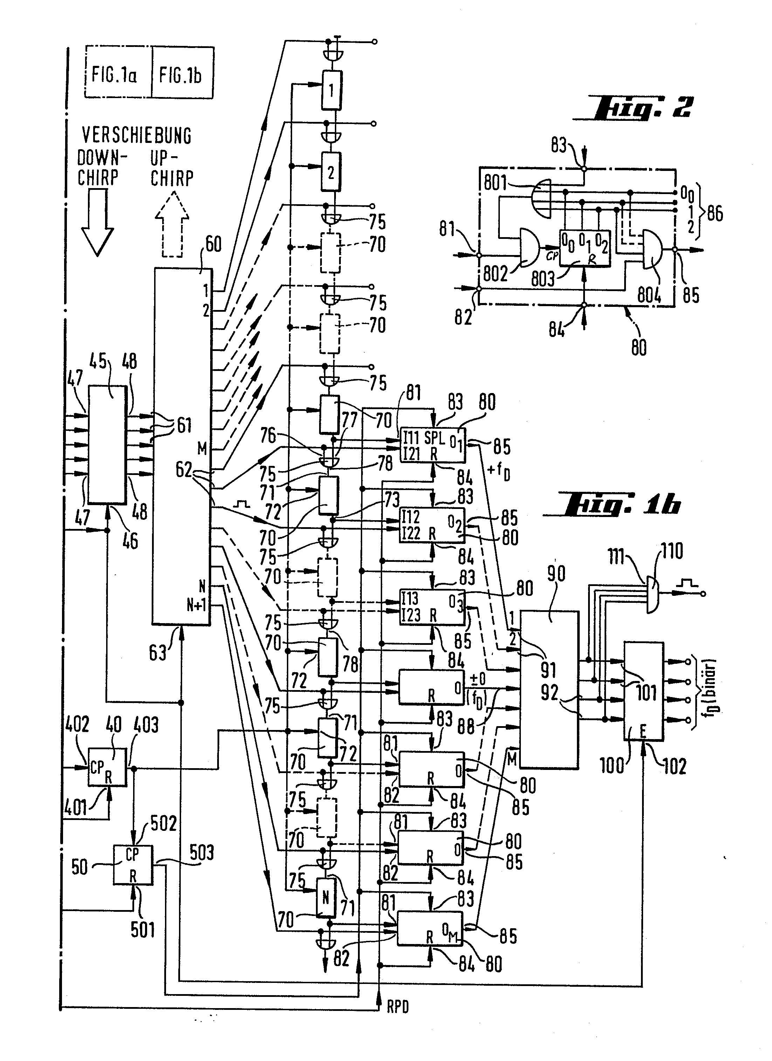

Wie aus Fig. 2 ersichtlich ist, enthalten die Zählschaltungen 80 ein ODER-Gatter 801, dessen Ausgang an einen ersten Eingang eines UND-Gatters 802 gelegt ist. An einen zweiten Eingang dieses UND-Gatters 802 liegt der Eingang 81 an. Der Ausgang dieses UND-Gatters 802 ist an den Zähleingang eines Zählers 803 geführt. Die Ausgänge $O_0$, $O_1$, $O_2$ des Zählers 803 sind an die Eingänge des ODER-Gatters 801 und an Eingänge eines weiteren UND-Gatters 804 gelegt. An einen der Eingänge des UND-Gatters 804 ist der Eingang 82 gelegt. Der Ausgang des UND-Gatters 804, der den Ausgang 85 der Zählschaltung 80 bildet, ist an den dieser Zählschaltung zugeordneten Eingang 91 des Prioritätsdekoders 90 gelegt. Die Ausgänge 92 des Prioritätsdekoders 90 sind einerseits an die Eingänge 101 des Ergebnisspeichers 100 und andererseits an die Eingänge 111 eines UND-Gatters 110 gelegt.

Nachstehend ist die Wirkungsweise der geschilderten Schaltung erläutert:
Ein am ersten Signaleingang 1 auftretendes, unbekanntes, breitbandiges, insbesondere transientes, sinusförmiges Signal gelangt an das Bandpaßfilter 6, durch welches derjenige Frequenzbereich, welcher untersucht werden soll bzw. innerhalb dessen ein Signal aufgefunden werden soll, bestimmt wird. Das im Frequenzbereich des Filters 6 liegende, durchgelassene Signal wird durch den Spannungskomparator 7 (engl.Zero-Crossing-Dedector) in ein Recht-ecksignal umgewandelt, durch dessen Periodendau-er die Nulldurchgänge des sinusförmigen Signal repräsentiert werden. Dieses Rechtecksignal gelangt über das UND-Gatter 11 und das ODER-Gatter 12 zum RS-Flip-Flop 10. Durch die erste positive Flanke dieses Recktecksignals, die an den Set-Eingang 101 des Flip-Flops 10 gelegt ist, wird an dessen Q-Ausgang 103 ein High-Signal und an dessen $\overline{Q}$-Ausgang 104 ein Low-Signal bewirkt. Da durch das am $\overline{Q}$-Ausgang 104 auftretende Low-Signal an den Reset-Eingang 201 des ersten Zählers 20 kein Impuls gelangt, kann durch diesen Zähler 20 die Zählung der vom Oszillator 36 abgegebenen Abtastimpulse einsetzen. Der vom vorhergehenden Zählvorgang im zweiten Zähler 30 enthaltene Zählerinhalt wird dann gelöscht, sobald die negative Flanke auftritt, da diese durch den Inverter 13 invertiert wird, wodurch das am Q-Ausgang 103 befindliche High-Signal an den Reset-Eingang 301 des zweiten Zählers 30 gelangt. Hierdurch wird dieser auf Null zurückgesetzt.

Die vom Oszillator 36 erzeugten Takt-Abtastsignale gelangen an den Eingang 202 des ersten Zählers 20 und werden in diesem gezählt. Obgleich diese Takt-Abtastsignale auch an das UND-Gatter 15 abgegeben werden, bleiben sie jedoch bei diesem wirkungslos, da an dessen zweiten Eingang das Low-Signal vom $\overline{Q}$-Ausgang 104 des Flip-Flops 10 anliegt. Die Takt-Abtastsignale werden weiters im dritten Zähler 40 gezählt. Sobald der Zähler 40 vollständig durchgezählt hat bzw. voll ist, wird von diesem an den Eingang 502 des vierten Zählers 50 ein Ausgangssignal abgegeben, das durch diesen Zähler 50 gezählt wird. Demnach werden durch den dritten Zähler 40 und den vierten Zähler 50 Impuls-steuerungen in vorgegebenen Verhältnissen be-wirkt.

Die Zählung der Takt-Abtastsignale im ersten Zähler 20 wird durch die positive Flanke des Rechtecksignals aufgrund eines am ersten Signaleingang 1 auftretenden Signals eingeleitet. Sobald der erste Zähler 20 diejenige Anzahl der Takt-Abtastsignalimpulse gezählt hat, die seinem Zählerinhalt entspricht, welcher durch den Kodierschalter 21 vorprogrammiert wurde, wird über den Kodierschalter 21 und das UND-Gatter 23 an den Reset-Eingang 102 des Flip-Flops 10 ein Signal abgegeben, durch welches das Flip-Flop 10 zurückgestellt wird, sodaß an seinem Q-Ausgang 103 ein Low-Signal und an seinem $\overline{Q}$-Ausgang 104 ein High-Signal auftritt. Hierdurch werden der erste Zähler 20 ebenso wie der dritte Zähler 40 und der vierte Zähler 50 auf Null zurückgestellt. Da hierdurch weiters an das UND-Gatter 15 ein High-Signal gelangt, gelangen die Takt-Abtastimpulse vom Oszillator 36 an den Zählereingang 302 des zweiten Zählers 30, wodurch dieser zu zählen beginnt.

Die Zählung im zweiten Zähler 30 erfolgt so lange, bis die nächste positive Flanke, d.h. die nächste Flanke des Rechteck signals, aufgrund eines Signals vom ersten Signaleingang 1 einlangt. Durch diese positive Flanke beginnt der erste Zähler 20 wieder zu zählen und wird die Zählung im zweiten Zähler 30 unterbrochen. Das Ergebnis des vorhergehenden Zählung wird dadurch kurzzeitig gespeichert, daß die Ausgänge 304 des zweiten Zählers 30, deren jeweils einer einen bestimmten Zählerstand repräsentiert, an die zugeordneten Eingänge 47 des Zwischenspeichers 45 gelegt sind. Die Dauer der Einspeicherung der Ausgangssignale des zweiten Zählers 30 im Zwischenspeicher 45 wird durch das Ausgangssignal des Monoflops 29, das eine kurze Dauer aufweist, bestimmt. Das Monoflop 29, das über die abfallende Flanke des Signals am $\overline{Q}$-Aus-gang 104 des RS-Flip-Flops 10 ausgelöst wird, bewirkt somit die Einspeicherung der Ausgangssignale des zweiten Zählers 30 im Zwischenspeicher 45. Der Zustand des Zwischenspeichers 45 bleibt bis zur nächsten Einspeicherung erhalten. Der Zählerinhalt des zweiten Zähler 30 wird während des folgenden Zählvorganges durch die hintere Flanke des vom Spannungskomparator 7 abgegebenen Rechtecksignales gelöscht.

Sobald also am ersten Signaleingang 1 ein Signal auftritt, wird dessen Periodendauer dadurch ermittelt, daß die vom Oszillator 36 abgegebenen Abtastimpulse zuerst durch den ersten Zähler 20 und anschließend durch den zweiten Zähler 30 gezählt werden. Soferne das Eingangssignal eine Länge nahe der unteren Grenze des Meßbereiches aufweist, bewirkt das Zählerergebnis des zweiten Zählers 30 nur geringe Werte und zwar mindestens einen Impuls. Soferne das Eingangssignal eine größere Länge aufweist, wird vom zweiten Zähler 30 eine größere Anzahl von Abtastimpulsen gezählt. Um diese Wirkungsweise zu ermöglichen, muß die Frequenz der vom Oszillator 36 abgegebenen Abtastimpulse wesentlich größer, z.B. etwa 100 oder 1000 mal größer, sein, als die Frequenz des am ersten Signaleingang 1 auftretenden Signals. Die vom zweiten Zähler 30 abgegebenen Zählwerte werden z.B. in Dual-oder BCD-Form an den ersten Zwischenspeicher 45 abgegeben. Dabei repräsentieren die einzelnen Ausgangswerte des zweiten Zählers 30 bzw. die Werte an den Eingängen des Zwischenspeichers 45 bestimmte, zugeordnete Frequenzen. Diese Werte werden in der Folge an der Dekoder 60 abgegeben und bewirken an dessen Ausgängen 62, die gleichfalls bestimmte Frequenzen repräsentieren, den Frequenzen entsprechende Ausgangssignale.

Der Komparator 7 dient dazu, die sinusförmigen Eingangssignale in Rechtecksignale, deren Periodendauer durch die Nulldurchgänge der Eingangssignale bestimmt werden, umzuwandeln. Der Meßbereich für die Dauer dieser Signale ist einerseits durch die minimale Zählung, welche durch den ersten Zähler 20 bewirkt wird, und andererseits durch die maximale Zählung, welche durch den zweiten Zähler 30 erfolgt, bestimmt. Die Zählwerte des ersten Zählers 20 sind in diesen mittels des Kodierschalters 21 einprogrammiert.

Die Frequenz der vom Oszillator 36 abgegebenen Abtastimpulse muß mittels eines Referenzsignals und einer Referenzsteuerung, durch welche eine Kalibrierung des Oszillators 36, also eine Einstellung seiner Arbeitsfrequenz, möglich ist, einstellbar sein. Hiezu dienen der zweite Signaleingang 2, an den ein Referenzsignal, das von einem Referenzgenerator abgegeben wird, anliegt und der dritte Signaleingang 3, an den das Referenzsignal anliegt. Das Referenzsignal weist die Soll-Frequenz auf, welche denjenigen Frequenzbereich angibt, in welchem der Frequenzverlauf des Eingangssignals ermittelt werden soll. Die Steuerung des Oszillators 36 erfolgt während eines Zeitraumes, der durch das Referenzsteuersignal bestimmt wird. Durch das Anlegen des Referenzsteuersignals an den dritten Signaleingang 3 wird über den Inverter 19 das UND-Gatter 11 gesperrt, wodurch dasEingangssignal nicht mehr an den Flip-Flop 10 gelangt. Während der darauffolgenden Zählung im zweiten Zähler 30 treten an denjenigen Ausgängen 304, welche an das UND-Gatter 16 gelegt sind und welche mittlere Zählwerte repräsentieren, Ausgangssignale auf. Da an das UND-Gatter 16 auch das Referenzsteuersignal anliegt, gelangt aufgrund derselben über das ODER-Gatter 12 an den Set-Eingang 101 des FLip-Flop 10 ein Impuls, durch welchen in der vorstehend beschriebenen Weise der erste Zähler 20 zu zählen beginnt. Sobald die negative Flanke des Eingangssignals auftritt, wird der Zählerstand des zweiten Zählers 30 gelöscht. Der erste Zähler 20 zählt bis zu demjenigen Wert, welcher durch den Codierschalter 21 bestimmt ist. In der Folge beginnt auch wieder der zweite Zähler 30 zu zählen und zählt bis zu demjenigen Wert, welcher durch denjenigen mittleren Ausgang 304, welcher an das UND-Gatter 16 gelegt ist, bestimmt ist, worauf der vorstehend beschriebene Ablauf wiederholt wird. Hierdurch tritt am Q-Ausgang 103 des Flip-Flop 10 ein Rechtecksignal auf, dessen Frequenz in genauer Relation zur Frequenz der vom Oszillator 36 abgegebenen Abtastimpulse steht.

Dieses Rechtecksignal, das an den Phasendetektor 24 angelegt ist, wird in diesem mit dem Referenzsignal verglichen. Dadurch wird ein Differenzsignal erzeugt, welches über den Schalter 27, der gleichfalls mit dem Referenzsteuersignal beaufschlagt ist, und das Tiefpaßfilter 35 an den Steuereingang 37 des Oszillators 36 als Steuersignal angelegt wird, wodurch dessen Frequenz solange geregelt wird, bis dieselbe in einem vorgegebenen Verhältnis zur Frequenz des Referenzsignals steht. Durch dieses Verhältnis wird die Meßauflösung unmittelbar bestimmt. Bei einem Verhältnis von 1:100 wird eine Auflösung von 1% erreicht. Bei einem Verhältnis von 1:1000 wird eine Auflösung von 0,1% erreicht. Dabei wird ein exaktes Verhältnis angestrebt.

Von denjenigen Abtastimpulsen, welche innerhalb der Periode des Referenzsignals abgegeben werden, werden beispielsweise 90% im ersten Zähler 20 und 10% im zweiten Zähler 30 gezählt. Soferne das Eingangssignal eine größere Periodenlänge als das Referenzsignal, also eine kleinere Frequenz aufweist, wird im zweiten Zähler 30 eine geringere Anzahl von Abtastimpulsen gezählt. Soferne hingegen das Eingangssignal eine größere Periodenlänge als das Referenzsignal aufweist, wird im zweiten Zähler 30 eine größere Anzahl von Abtastimpulsen gezählt. In jedem Fall werden Änderungen in der Periodenlänge, d.h. in der Frequenz, des Eingangssignals gegenüber dem Referenzsignal durch die Zählung im zweiten Zähler 30 festgestellt.

Da das Tiefpaßfilter 35 mit einem Operationsverstärker aktiv ausgebildet ist, wirkt es beim Ausschalten als Abtast- und Halteschaltung. Hierdurch wird am Ausgang eine vorbestimmte Zeitspanne der Spannungswert genau gehalten, wodurch eine Meßphase mit kurzzeitiger Stabilisierung erreicht wird, innerhalb welcher der Oszillator 36 mit der angestrebten Frequenz Abtastsignale abgibt. Aufgrund der vorstehend erläuterten Wirkungsweise der Schaltung wird die Frequenz des Oszillators 36 von der Frequenz des Referenzsignales kurzzeitig genau bestimmt, wobei dessen Einstellung während der Signaldauer des Referenzsteuersignals erfolgt.

Um eine Abtastung bzw. Erfassung eines am ersten Signaleingang 1 auftretenden Signales vornehmen zu können, besteht weiters das Erfordernis, daß die Frequenz dieses Signales in demjenigen Frequenzbereich liegt, der durch das Bandpaßfilter 6 bestimmt wird. Um demnach durch das Bandpaßfilter 6 eine Vielzahl von Bereichen erfassen zu können, ist es einerseits erforderlich, daß die Frequenz des Oszillators 36 veränderbar ist. Diese Änderung wird über den Steuereingang 37 durch das Referenzsignal bewirkt. Da jedoch bei einem vorgegebenen Frequenzbereich des Bandpaßfilters 6 dieses Signal außerhalb der Bandbreite des Bandpaßfilters 6 liegen kann, muß andererseits auch die Mittenfrequenz des Bandpaßfilters 6 in der erforderlichen Weise angeglichen werden. Dies wird dadurch bewirkt, daß die Mittenfrequenz des Bandpaßfilters 6 mittels des Frequenz-Spannungskonverters 8 auf die Frequenz des Referenzsignales abgestimmt wird. Um ununterbrochen eintreffende Signale auswerten zu können, müssen mindestens zwei derartige Bandpaßfilter 6 vorgesehen sein, wobei jeweils ein Bandpaßfilter wirksam ist und während dessen das zweite Bandpaßfilter in seiner Mittenfrequenz verändert wird, worauf wiederum dieses zur Wirkung gebracht wird und gleichzeitig das erste Bandpaßfilter in seiner Mittenfrequenz geregelt wird.

Hierdurch wird der gesamte Frequenzbereich erfaßt, in welchem diejenigen Chirpssignale, welche aufgefunden werden sollen, liegen. Ergänzend wird darauf verwiesen, daß die Bandbreite der Bandpaßfilter 6 etwa ein Achtel des Frequenzbereiches eines Ultraschall-Chirpssignales aufweist, wodurch für den gesamten Meßvorgang zwei Bandpaßfilter 6 abwechselnd etwa viermal zur Wirkung gebracht werden.

Soferne aufgrund eines an einem der Ausgänge 48 des Zwischenspeichers 45 auftretenden Signales an einen der Eingänge 61 des Dekoders 60 ein Signal gelangt, wodurch am zugeordneten Ausgang 62 des Dekoders 60 ein Signal bewirkt wird, wird dieses - mit Ausnahme des letzten Ausganges - über das zugeordnete ODER-Gatter 75 an den Eingang 71 des zugeordneten Schiebere gisters 70 gelegt. Vom dritten Zähler 40 werden die Steuereingänge 72 der einzelnen Schieberegister 70 mit Schiebeimpulsen beaufschlagt. Bei einer vorgegebenen Anzahl von N Speicherelementen in den Schieberegistern 70 sind N + 1 vom dritten Zähler 40 abgegebene Schiebeimpulse erforderlich, um die Eingangssignale durch die einzelnen Schieberegister 70 hindurchzuschieben, worauf sie am Ausgang des betreffenden Schieberegisters 70 auftreten. Im vorliegenden Ausführungsbeispiel enthalten die einzelnen Schieberegister 70 jeweils 16 Speicherelemente.

Während der Zählung durch den ersten Zähler 20 werden die vom Oszillator 36 abgegebenen Taktimpulse vom dritten Zähler 40 durch einen vorgegebenen Faktor geteilt. Im Ausführungsbeispiel ist dieser Faktor durch den Wert 20 gebildet. Soferne also vom ersten Zähler 20 beispielsweise 340 Taktimpulse gezählt werden, werden in diesem Zeitraum vom dritten Zähler 40 17 Taktimpulse abgegeben. Diese 17 Taktimpulse werden über die Steuereingänge 72 an die einzelnen Schieberegister 70 angelegt und bewirken ein Verschieben der in diese eingelesenen Dateninhalte. Dabei werden mit Auftreten jeweils eines Taktimpulses die in den einzelnen Speicherzellen enthaltenen Daten jeweils um eine Speicherzelle weiterverschoben. Somit werden bei Auftreten von 17 Taktimpulsen die in den einzelnen Schieberegistern 70 enthaltenen Daten gleichzeitig durch diese hindurchgeschoben. Das bedeutet, daß mit dem 17. Taktimpuls durch das betreffende Schieberegister 70 dasjenige Datenbit in das erste Speicherelement eines in der Kette liegenden Schieberegisters 70 eingespeichert wird, das ursprünglich am Eingang des vorhergehenden Schieberegisters 70 angelegt ist. Durch das Weiterverschieben werden diejenigen Datenbits, welche an die Eingänge 71 der einzelnen Schieberegister 70 anliegen, von oben nach unten durchgeschoben.

Wenn z.B. in einem der Schieberegister 70 fünf Speicherelemente schon besetzt waren und vom Eingang ein sechstes Datenbit eingelesen wird, wird dieses gleichzeitig mitgeschoben, wodurch im anschließenden Schieberegister 70 sechs aufeinanderfolgende Datenbits enthalten sind. Die letzten Datenbits, welche von einem der Schieberegister 70 zum nächsten weitergeschoben werden, sind diejenigen, die den letzten sechs Impulsen der Impulsfolge der 17 Impulse entsprechen.

Soferne eine Gruppe von sieben Impulsen in Betracht gezogen wird, wird dann ein Meßergebnis als erzielt bewertet, wenn bei einer aufeinanderfolgenden Gruppe von sieben Impulsen ein Anfangsimpuls, ein Endimpuls und zwischen diesen beiden Impulsen noch mindestens drei weitere Impulse auftreten. Voraussetzung dafür, daß ein verwertbares Meßergebnis vorliegt, ist somit, daß in einer Gruppe, welche sich in einem Zeitraum von sieben Schiebeimpulsen befindet, mindestens fünf Impulse enthalten sind, wobei jedenfalls ein Anfangsimpuls und ein Endimpuls auftreten müssen.

Soferne durch die Belegung eines der Ausgänge 304 des zweiten Zählers 30 eine bestimmte Frequenz des erfaßten Signals repräsentiert wird, die über den Speicher 45 an den Dekoder 60 abgegeben wird, tritt an einem von dessen Ausgängen 62, nämlich dem der entsprechenden Frequenz zugeordneten Ausgang, ein Signalimpuls auf. Dieser Signalimpuls wird über das zugeordnete ODER-Gatter 75 dem anliegenden Schieberegister 70 geführt. Durch die Taktsignale, welche vom Oszillator 36 abgegeben werden, werden innerhalb einer Periode des Referenzsignales vom dritten Zähler 40 im vorliegenden Fall 17 Schiebeimpulse abgegeben, welche bewirken, daß dieser Signalimpuls durch das entsprechende Schieberegister 70 hindurchgeführt und in die erste Speicherzelle des nächsten Schieberegisters 70 eingespeichert wird. Soferne in der Folge an dem daneben liegenden Ausgang 62 des Dekoders 60 deshalb, da ein in seiner Frequenz veränderliches Signal erfaßt wurde, weswegen der daneben liegende Ausgang 62 belegt wurde, ein Signalimpuls auftritt, gelangt dieser in das zugeordnete Schieberegister, das an das vorerst erwähnte Schieberegister anliegt, wobei in der Folge in diesem Schieberegister zwei Speicherzellen mit Signalimpulsen belegt sind. Soferne in der weiteren Folge an den daneben liegenden Ausgängen 62 des Dekoders 60 weitere Signalimpulse auftreten, werden auch diese den zugeordneten Schieberegistern 70 zugeführt, wodurch aufeinander folgende Speicherzellen der Schieberegister 70 mit Signalimpulsen belegt sind. Diese werden in der weiteren Folge abgetastet.

Durch die an den Ausgängen 62 des Dekoders 60 auftretenden Signalimpulse und durch die vom dritten Zähler 40 abgegebenen Schiebeimpulse werden die in den einzelnen Schieberegistern 70 befindlichen Speicherzellen aufeinanderfolgend mit Signalimpulsen belegt. Soferne an aufeinanderfolgenden Ausgängen 62 des Dekoders 60 Signalimpulse aufgetreten sind, wird somit nach einer ersten Periode in einem ersten Schieberegister 70 eine einzige Speicherzelle, werden nach zwei Perioden in einem zweiten Schieberegister zwei Speicherzellen und werden in der Folge weitere Speicherzellen der in der Kette nachfolgenden Schieberegister 70 aufeinanderfolgend mit Signalimpulsen belegt. Demnach kann z.B. das fünfte Schieberegister 70 in seinen fünf ersten Speicherzellen mit Signalimpulsen belegt sein. Soferne hierauffolgend an dieses Schieberegister 70 vom dritten Zähler 40 17 Abtastimpulse abgegeben werden, werden diese Werte durch das betreffende Schieberegister 70 hindurchgeschoben und treten sie aufeinanderfolgend an dessen Ausgang auf. Die dargestellte Schaltung bezieht sich dabei auf die Ermittlung eines Chirpssignals mit abnehmender Frequenz ("Down-Chirp"). Zur Ermittlung eines Chirpssignales mit steigender Frequenz ("Up-Chirp") müßte die Kette der Schieberegister so angeordnet sein, daß die Verschiebung der Signalimpulse von unten nach oben erfolgt.

Die an den Ausgängen der Schieberegister 70 auftretenden Signalimpulse liegen an dem Eingang 81 der zugeordneten Zählschaltung 80 an, welche in Fig. 2 dargestellt ist. Nach zwölf Schiebeimpulsen wird an den Sampleeingang 83 der Zählschaltung 80 vom vierten Zähler 50 ein Sampleimpuls angelegt, durch welchen das ODER-Gatter 801 aktiviert wird. Hierdurch können in weiterer Folge über das UND-Gatter 802 die einzelnen in den Speicherelementen befindlichen Werte an den Zähler 803 abgegeben werden, worauf sie durch diesen gezählt werden. Hierdurch treten an den dual kodierten Zählerausgängen des Zählers 803 Signalimpulse auf, die das ODER-Gatter 801 in seiner Offenstellung halten, sowie die die Öffnung des UND-Gatters 802 bewirken, wodurch sämtliche Belegungen der Speicherelemente durch den Zähler 803 gezählt werden. Das Element 80 kann aufgrund seiner Funktion als Pulsdetektor bezeichnet werden.

Die an den Ausgängen des Zählers 803 anliegenden kodierten Werte gelangen an das UND-Gatter 804 und an einen Dual-Ausgang 86. Sobald am Ende der Abtastung vom Dekoder 60 über den Eingang 82 an den Pulsdetektor 80 ein weiteres Signal gelangt, wird durch dieses Signal das UND-Gatter 804 geöffnet, wodurch vom Pulsdetektor 80 an dessen Ausgang 85 ein Signal abgegeben wird, welches an den zugeordneten Eingang des Prioritätsdekoders 90 geführt wird. Soferne also innerhalb einer Folge von sieben Signalimpulsen mit einem Anfangsimpuls und mit einem Endimpuls eine vorgegebene Mindestanzahl von Signalimpulsen auftritt, wird am Pulsdetektor 80 ein Ausgangsimpuls bewirkt, der dem Prioritätsdekoder 90 zugeführt wird.

Durch das Monoflop 31 werden gegenüber dem Monoflop 29 zeitlich versetzte Impulse abgegeben, durch welche die Signalinhalte der Pulsdetektoren 80 gelöscht werden.

Die Ausgänge 85 der einzelnen Pulsdetektoren 80 repräsentieren gegenüber einem mittleren Ausgang 88 die Abweichungen der Frequenzen der Eingangssignale von der Frequenz des Referenzsignales, welche Abweichungen in der Radar- oder Sonartechnik als Dopplerfrequenzverschiebung bezeichnet werden. Diese Abweichungen werden im Dekoder 90 nach ihrem zeitlichen Eintreffen ermittelt, wobei der zuerst eingelangte Impuls binär kodiert und im Ergebnisspeicher 100 abgespeichert wird.

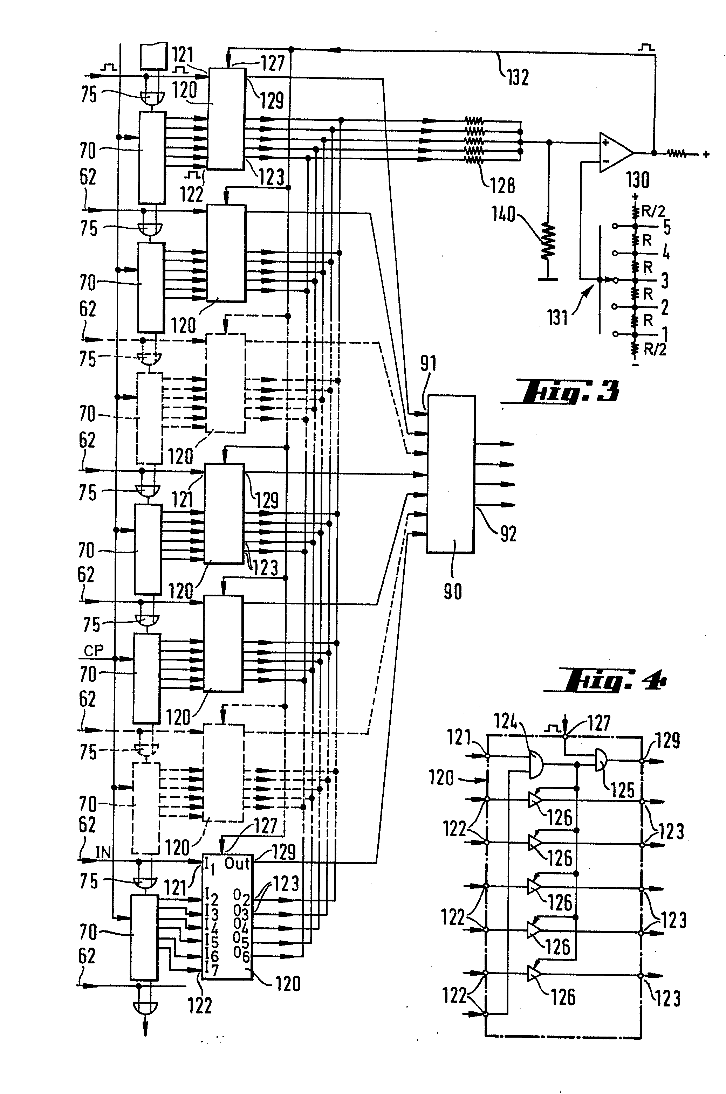

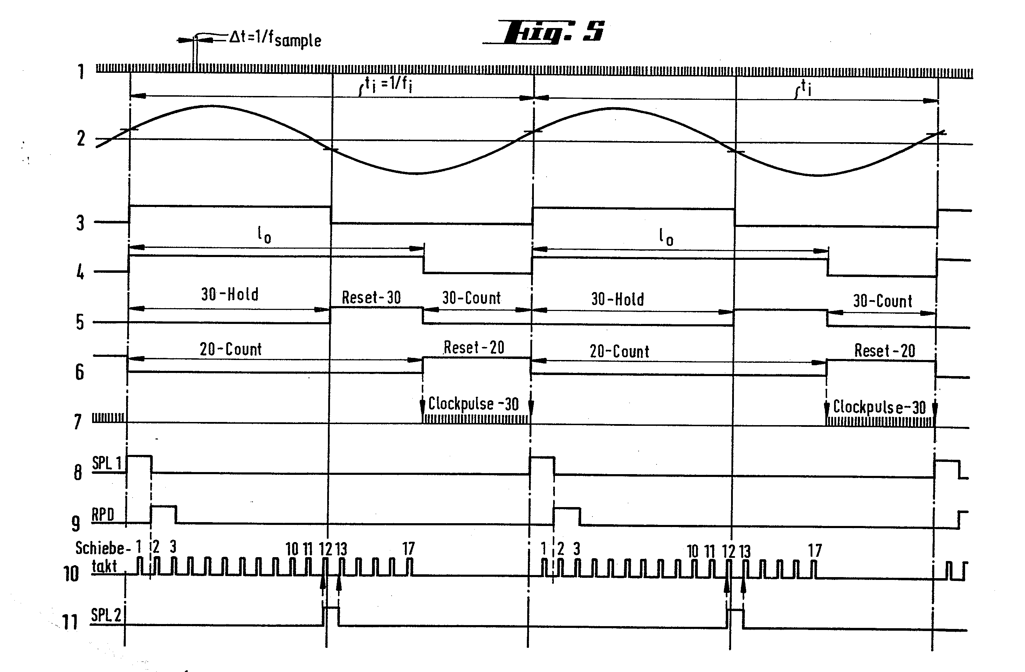

In den Fig. 3 und 4 ist eine Variante zur Ermittlung der in den Schieberegistern 70 enthaltenen Datenwerte dargestellt. Dabei erfolgt die Abtastung der Datenwerte nicht seriell, wie dies bei der Schaltung gemäß Fig. 1 der Fall ist, sondern vielmehr parallel. Auch in dieser Schaltung ist eine Kette von Schieberegistern 70, zwischen welchen sich ODER-Gatter 75 befinden, vorgesehen. Dabei ist jedoch jeweils eine Gruppe von Speicherelementen dieser einzelnen Schieberegister 70 über Ausgänge herausgeführt, wobei diese einzelnen Ausgänge an zweite Eingänge 122 von gesteuerten Pufferschaltungen 120 gelegt sind. Diese Pufferschaltungen 120 weisen Tri-State Ausgänge 123 auf. Die gesteuerten Pufferschaltungen 120 enthalten zwei UND-Gatter 124 und 125 und weiters eine Mehrzahl von Tri-State-Puffern 126.

Die Funktion dieser Schaltung ist wie folgt: Beim Meßvorgang ist jeweils nur ein Ausgang 62 des Dekoders 60 mit einem Signal belegt. Dieses Signal gelangt in der beschriebenen Weise über eines der ODER-Gatter 75 in eines der Schieberegister 70. Weiters wird dieses Signal über den ersten Eingang 121 an das in der zugeordneten Pufferschaltung 120 befindliche UND-Gatter 124 gelegt. Soferne der letzte maßgebliche Ausgang des zugeordneten Schieberegisters 70 mit einem Signal belegt ist, gelangt dieses über den zugeordneten der zweiten Eingänge 122 der Pufferschaltung 120 an den zweiten Eingang des UND-Gatters 124, wodurch an dessen Ausgang ein Signal auftritt.Durch dieses Signal werden die in der Pufferschaltung 120 vorgesehenen einzelnen Puffer 126 aktiviert, wodurch die gegebenenfalls an deren Eingänge anliegenden Signale an die zugeordneten Ausgänge 123 der Pufferschaltung 120 weitergeleitet werden. Es brauchen dabei nicht alle Ausgänge mit Signalen belegt zu sein, damit die weitere Funktion der Schaltung gewährleistet ist. Durch Anlegen eines Signales werden die einzelnen Tri-State-Puffer 126 von ihrem hochohmigen Zustand in den aktiven Zustand übergeführt, wodurch die allenfalls an ihren Eingängen anliegenden Signale an die Ausgänge 123 der Pufferschaltung 120 weitergeleitet werden.

Diese Ausgangssignale werden über Widerstände 128, die jedem Ausgang 123 zugeordnet sind, an den Eingang eines Komparators 130 weitergeleitet. An diesen Eingang ist zudem ein hochohmiger Widerstand 140 angelegt. Durch die Widerstände 128 wird ein Spannungsteiler gebildet, dessen Ausgang an den einen Eingang des Komparators 130 gelegt wird. Am zweiten Eingang des Komparators 130 liegt eine Schwellspannung an, die gleichfalls durch einen Spannungsteiler 131 bestimmt wird.

Sobald ein Eingangssignal die eingestellte Schwellspannung überschreitet, tritt am Ausgang des Komparators 130 ein Signal auf, das über eine Rückkopplungsleitung 132 an die Pufferschaltung 120 zurückgeführt und an einen Rückkopplungseingang 127 der Pufferschaltung 120 gelegt wird. In der Folge wird hierdurch auch das UND-Gatter 125 aktiviert, wodurch am Ausgang 129 dieser Pufferschaltung 120 ein Signal auftritt. Dieses Signal zeigt deshalb ein Chirpssignal an, da aus einer vorgegebenen Anzahl von Ausgangssignalen eine bestimmte Anzahl erreicht wurde, weswegen das Kriterium für das Vorhandensein eines Chirpssignales erfüllt wurde. Die Erfüllung dieses Kriteriums ist dadurch gegeben, daß in einer vorgegebenen Gruppe ein erster Impuls, ein letzter Impuls und zwischen diesen beiden Impulsen eine vorgegebene Anzahl von weiteren Impulsen aufgetreten sind. Im übrigen wirkt die Schaltung so, wie dies in der vorliegenden Bechreibung erläutert ist.

In Fig. 5 sind die an einzelnen Stellen der Schaltung auftretenden Signale dargestellt:

In Zeile 1 sind die vom Oszillator 36 als Abtast-Taktimpulsgeber abgegebenen Taktsignale dargestellt.

In Zeile 2 ist das Ausgangssignal des Bandpaßfilters 6 in Form von zwei vollen Wellen dargestellt.

In Zeile 3 ist das mittels des Spannungskomparators 7 in eine Rechteckspannung umgewandelte Ausgangssignal dargestellt.

In Zeile 4 ist dasjenige Signal dargestellt, das am Q-Ausgang 103 des Flip-Flop 10 auftritt, dessen Länge $L_0$ durch die durch den ersten Zähler 20 bewirkte Zählung bestimmt wird.

In Zeile 5 ist das Ausgangssignal des UND-Gatters 14 dargestellt, durch welches die Rückstellung des zweiten Zählers 30 bewirkt wird.

In Zeile 6 ist das am $\bar{Q}$-Ausgang 104 des Flip-Flop 10 auftretende Signal dargestellt, durch welches die Zählung im zweiten Zähler 30 bewirkt wird

In Zeile 7 sind die durch den zweiten Zähler 30 gezählten Abtastimpulse dargestellt.

In Zeile 8 sind die vom ersten Monoflop 29 abgegebenen Rechtecksignale dargestellt, während deren Dauer die Ausgangssignale des zweiten Zählers 30 in den Zwischenspeicher 45 eingespeichert werden.

In Zeile 9 sind die vom zweiten Monoflop 31 abgegebenen Signale dargestellt, durch welche die Löschung der in den Pulsdetektoren 80 enthaltenen Werte erfolgt.

In Zeile 10 sind die vom dritten Zähler 40 an die Schieberegister 70 abgegebenen Schiebeimpulse dargestellt.

In Zeile 11 sind die vom vierten Zähler 50 an die Pulsdetektoren 80 abgegebenen Abtastimpulse dargestellt.

Vom Oszillator 36 werden entsprechend der gewählten bzw. bestimmten Frequenz Taktimpulse bzw. Abtastimpulse (Zeile 1) abgegeben. Durch ein im vorgegebenen Frequenzbereich eingehendes Chirpssignal (Zeile 2) wird durch den Spannungskomparator 7 ein Rechtecksignal (Zeile 3) erzeugt, dessen Flanken - mit einer geringen Verzögerung durch die Nulldurchgänge des Signals bestimmt sind. Durch dessen positive Flanke wird im ersten Zähler 20 die Zählung der Abtastimpulse über eine zeitliche Länge $l_0$ (Zeile 4), welche durch den Kodierschalter 21 bestimmt wird, eingeleitet.

Sobald die negative Flanke des Rechtecksignals auftritt, gelangt an den zweiten Zähler 30 ein Resetsignal (Zeile 5), durch welches der Zählerinhalt des zweiten Zählers 30 gelöscht wird. Sobald über UND-Gatter 23 ein Ausgangssignal des ersten Zählers 20 an den Reseteingang 102 des Flip-Flop 10 gelangt, wird dieses umgeschaltet. Hierdurch wird ein Signal (Zeile 6) bewirkt, durch welches einerseits der Inhalt des ersten Zähler 20 gelöscht wird und durch welches andererseits an den zweiten Zähler 30 über das UND-Gatter 15 die Takt-Abtastsignale gelangen, welche in der Folge durch den zweiten Zähler gezählt werden (Zeile 7). Mit der positiven Flanke des folgenden Rechteckimpulses wird die Zählung im zweiten Zähler 30 unterbrochen und wird hierauf dessen Zählerinhalt vom Zwischenspeicher 45 übernommen und gespeichert. Das erste Monoflop 29, das über das Flip-Flop 10 durch die positiven Flanken des Eingangssignals gesteuert wird, gibt an den Zwischenspeicher 45 und an den Dekoder 60 Steuerimpulse (Zeile 8) ab, über deren Dauer die im Speicher 45 enthaltenen Signale an den Dekoder 60 weitergeleitet werden. Die positiven Flanken dieser Impulse bestimmen den Zeitpunkt der Einspeicherung der Signalwerte in den Zwischenspeicher 4. Die Signaldauer dieser Impulse bestimmt diejenige Zeitdauer, innerhalb welcher vom Dekoder 60 an einem seiner Ausgänge ein Ausgangssignal abgegeben wird. Somit entspricht die Länge der an einem der Ausgänge 62 des Dekoders 60 auftretenden Ausgangssignale der Länge derjenigen Impulse, die vom ersten Monoflop 29 abgegeben werden.

Vom zweiten Monoflop 31 werden Impulse (Zeile 9) abgegeben, welche gegenüber den vom ersten Monoflop 29 abgegebenen Impulsen zeitlich versetzt sind, wobei sie diesen nachfolgen, und durch welche die Signalinhalte der Zähler 80 gelöscht werden.

Vom dritten Zähler 40 werden Schiebeimpulse (Zeile 10) abgegeben, deren Anzahl zur Anzahl der Taktimpulse in einem vorgegebenen Verhältnis steht und durch welche die in den Speicherelementen der Schieberegister 70 enthaltenen Signale durch die Schieberegister 70 hindurchgeschoben werden. Durch den vierten Zähler 50 werden an die Pulsdetektoren 80 Impulse (Zeile 11) zur Abtastung von deren Inhalten und zur Weiterleitung derselben an der Prioritätsdekoder 90 abgegeben.

Die Schaltungsanordnung bis zum Dekoder 60 dient als digitaler Frequenzdiskriminator. Mit dieser Schaltung kann ein frequenzkonstantes Signal festgestellt und erfaßt werden und kann die relative Änderung von deren Frequenz zur Mittenfrequenz $f_0$ gemessen und angezeigt werden.

Mit dem nachfolgenden sequentiellen Pulsdetektor kann zudem auch eine bestimmte zeitliche Frequenzfolge, wie eine solche bei Chirp-signalen auftritt, ermittelt und erfaßt werden. Demnach kann diese Schaltung zur Erfassung von transienten Signalen herangezogen werden. Schließlich kann diese Schaltung zur korrelativen Signalkompression mit der Erfassung der Doppler-Frequenzverschiebung von Chirp-signalen verwendet werden.

1 erster Signaleingang

2 zweiter Signaleingang für das Referenzsignal

3 dritter Signaleingang für die Referenzsteuerung

6 Bandpaßfilter

7 Spannungskomparator

8 Frequenz-Spannungskonverter

10 Flip-Flop

    101 Set Eingang

    102 Reset-Eingang

    103 nominaler Q-Ausgang

    104 komplementärer Q̄-Ausgang

11 UND-Gatter

12 ODER-Gatter

13 Inverter

14 UND-Gatter

15 UND-Gatter

16 UND-Gatter

18 Inverter

19 Inverter

20 erster Zähler

    201 Reset-Eingang

    202 Zählereingang

    203 Ausgänge

21 Kodierschalter

22 Kontakte von 21

23 UND-Gatter

24 Phasendetektor

25 erster Eingang von 24

26 zweiter Eingang von 24

27 elektronischer Schalter

28 Eingang von 27

28a Steuereingang von 27

29 erstes Monoflop

30 zweiter Zähler

    301 Reset-Eingang

    302 Zähleingang

    303 Übertragungsausgang

    304 Ausgänge

31 zweites Monoflop

35 Tiefpaßfilter

36 Oszillator

37 Steuereingang von 36

40 dritter Zähler

    401 Reset-Eingang

    402 Zähleingang

    403 Ausgang

45 Zwischenspeicher

46 Steuereingang von 45

47 Eingänge von 45

48 Ausgänge von 45

50 vierter Zähler

    501 Reset-Eingang

    502 Zähleingang

    503 Ausgang

60 Decoder

61 Eingänge von 60

62 Ausgänge von 60

63 Steuereingang von 60

70 Schieberegister

71 Eingänge von 70

72 Steuereingang von 70

73 Ausgänge von 70

75 ODER-Gatter

76 erste Eingänge von 75

77 zweite Eingänge von 75

78 Ausgänge von 75

80 Schwellwert-Zählschaltungen

    801 ODER-Gatter

    802 UND-Gatter

    803 Zähler

    804 UND-Gatter

81 ersterEingang von 80

82 zweiterEingang von 80

83 Steuereingang von 80

84 Reset-Eingang von 80

85 Ausgang von 80

86 Dualausgänge von 80

88 Ausgang der mittleren Schwellwert-Zählschaltung

90 Prioritätsdekoder

91 Eingang von 90

92 Ausgang von 90

100 Ergebnisspeicher

101 Eingänge von 100

102 Steuereingang von 100

110 UND-Gatter

111 Eingänge von 110

120 Pufferschaltungen

121 erster Eingang von 120

122 zweite Eingänge von 120

123 Tri-State-Ausgänge von 120

124 UND-Gatter

125 UND-Gatter

126 Tri-State-Puffer

127 Rückkopplungseingang

128 Widerstände

129 Ausgang von 120

130 Komparator

131 Spannungsteiler

132 Rückkopplungsleitung

140 Widerstand

**Patentansprüche**

1. Schaltungsanordnung zur Erfassung von chirpmodulierten Signalen, insbesondere von chirpmodulierten Ultraschall-Signalen, mit mindestens zwei Zählern, einem spannungs- bzw. stromgesteuerten Oszillator sowie einer Kette von Gattern und getakteten Schieberegistern, gekennzeichnet durch einen digitalen Frequenzdiskriminator (10, 11, 12, 16, 19, 20 26, 28, 30, 35, 36, 45, 60), durch welchen die Frequenzänderungen der eingelangten chirpmodulierten Signale erfaßt und digitalisiert werden, wobei die digitalen Ausgangssignale der Frequenzdiskriminators (10, 11, 12, 16, 19, 20, 26, 28, 30, 35, 36, 45, 60) einem sequentiellen Pulsdetektor, der aus einer Kette von ODER-Gattern (75) und vom Oszillator (36) durch Zähler (40) getakteten Schieberegistern (70) besteht, zugeführt werden, in welchem diese Signale zeitlich aufeinanderfolgend aufsummiert werden, so daß der digitale Frequenzdiskriminator (2) und der sequentielle Pulsdetektor (70, 75) ein an die chirpmodulierten Signale angepaßtes Filter bilden, wobei nach Erreichung eines vorgegebenen Schwellwertes von mindestens einer aus einer Mehrzahl von Schwellwertschaltungen (80) an einen Prioritätsdekoder (90) ein Ausgangssignal abgegeben wird und vom Prioritätsdekoder (90) die Frequenz und den Zeitpunkt des eingelangten chirpmodulierten Signals ermittelt wird, wodurch dieses in einem vorgegebenen Frequenzbereich festgestellt und korrelativ ausgewertet wird, worauf das Ausgangssignal des Prioritätsdekoders (90) an eine Signalanzeige bzw. an einen Speicher abgegeben wird.

2. Schaltungsanordnung nach Anspruch 1, dadurch gekennzeichnet, daß der digitale Frequenzdiskriminator ein Flip-Flop (10), einen Abtastgenerator (36), mindestens zwei Zähler (20, 30) und eine Dekodierschaltung (60) enthält.

3. Schaltungsanordnung nach Anspruch 2, dadurch gekennzeichnet daß der digitale Frequenzdiskriminator weiters einen Phasendetektor (24), einen Steuerschalter (28) und ein Tiefpaßfilter (35) enthält, welche mit den Zählern (20, 30) eine phasensensitive PLL-Schaltung zur Regelung der Frequenz des Abtastgenerators (36) aufgrund eines Referenzsignales (2) bilden.

4. Schaltungsanordnung nach einem der Ansprüche 1 bis 3, dadurch gekennzeichnet, daß dem Eingang des Flip-Flop (10) ein Bandpaßfilter (6) zugeordnet ist, dessen Mittenfrequenz durch einen Frequenz-Spannungskonverter (8) oder einen Frequenz-Stromkonverter, welche vom Abtastgenerator (36) steuerbar sind, einstellbar ist.

5. Schaltungsanordnung nach Anspruch 4, dadurch gekennzeichnet, daß der Ausgang des Bandpaßfilters (6) an einen Spannungskomparator (7) gelegt ist, dessen Ausgang über ein UND-Gatter (11) und ein ODER-Gatter (12) an den Set-Eingang (10) des Flip-Flop (10) geführt ist.

6. Schaltungsanordnung nach einem der Ansprüche 1 bis 5, dadurch gekennzeichnet, daß die Ausgänge (22) eines ersten Zählers (20) an die Eingänge eines Kodierschalters (21), durch welchen die Länge des Zählvorganges im ersten Zähler (20) einstellbar ist, gelegt sind.

7. Schaltungsanordnung nach einem der Ansprüche 2 bis 6, dadurch gekennzeichnet, daß die Ausgänge eines zweiten Zählers (30) an die Eingänge eines Zwischenspeichers (45) gelegt sind, der zur Speicherung der momentanen Meßwerte dient und dessen Ausgänge (48) an die Dekodierschaltung (60) gelegt sind.

8. Schaltungsanordnung nach Anspruch 7, dadurch gekennzeichnet, daß die Ausgänge (62) der Dekodierschaltung (60) an den sequentiellen Pulsdetektor (70, 75) gelegt sind.

9. Schaltungsanordnung nach einem der Ansprüche 2 bis 8, dadurch gekennzeichnet, daß zwei weitere Zähler (40, 50) zur Steuerung des sequentiellen Pulsdetektor (70, 75), ein Monoflop (29) zur Steuerung eines Zwischenspeichers (45) und ein weiteres Monoflop (31) zur Steuerung der Schwellwertschaltungen (80) vorgesehen sind.

10. Schaltungsanordnung nach einem der Ansprüche 1 bis 9, dadurch gekennzeichnet, daß der sequentielle Pulsdetektor durch eine Kette von Schieberegistern (70), zwischen welchen ODER-Gatter (75) angeordnet sind, gebildet ist.

11. Schaltungsanordnung nach einem der Ansprüche 1 bis 10, dadurch gekennzeichnet, daß die Schwellwertschaltungen durch eine Gruppe von Zählschaltungen (80), in welchen UND-Gatter (802, 804), ODER-Gatter (801) und Zähler (803) angeordnet sind, gebildet sind.

12. Schaltungsanordnung nach einem der Ansprüche 2 bis 11, dadurch gekennzeichnet, daß ein Teil der Ausgänge (304) des zweiten Zählers (30) über ein UND-Gatter (16) und ein ODER-Gatter (12) an den Set-Eingang (10) des Flip-Flop (10) gelegt ist.

13. Schaltungsanordnung nach einem der Ansprüche 2 bis 12, dadurch gekennzeichnet, daß ein Eingang (3) für die Steuerung mittels eines Referenzsignales über einen Inverter (19), ein UND-Gatter (11) und ein ODER-Gatter (12) an den Set-Eingang (10) des Flip-Flop (10) gelegt ist.

14. Schaltungsanordnung nach einem der Ansprüche 1 bis 13, dadurch gekennzeichnet, daß jeder Ausgang (62) der Dekodierschaltung (60) einerseits an einen Eingang des zugeordneten, zwischen zwei Schieberegistern (70) befindlichen ODER-Gatters (75) und andererseits an einen Eingang (82) der zugeordneten Schwellwertschaltung (80) gelegt ist, wobei der Ausgang des zugeordneten Schieberegisters (70) an einen zweiten Eingang (81) der Schwellwertschaltung (80) gelegt ist.

15. Schaltungsanordnung nach einem der Ansprüche 2 bis 13, dadurch gekennzeichnet, daß die Ausgänges eines Teiles der in den Schieberegistern (70) befindlichen Speicherelemente herausgeführt und an Eingänge (122) von Tri-State-Pufferschaltungen (120) gelegt sind.

16. Schaltungsanordnung nach Anspruch 15, dadurch gekennzeichnet, daß die Ausgänge einer der Tri-State-Pufferschaltungen (120) überWiderstände (128) an den einen Eingang eines Komparators (130) gelegt sind, an dessen anderen Eingang ein Spannungsteiler (131) gelegt ist und dessen Ausgang an einen Rückkopplungseingang (127) dieser Tri-State-Pufferschaltung (120) geführt ist.

**Fig. 1a**

0286623

Fig. 3

Fig. 4

Fig. 5